# EUROPÄISCHE PATENTSCHRIFT

(11) **EP 0 551 585 B1**
(45) Veröffentlichungstag und Bekanntmachung des Hinweises auf die Patenterteilung: **05.03.1997**
(21) Anmeldenummer: 92119514.5
(22) Anmeldetag: 14.11.1992
(51) Int. Cl.: H03M 1/24

(54) **Drehbarer Codierer**
Rotary encoder
Codeur rotatif

(30) Priorität: 19.12.1991 DE 4141984
(43) Veröffentlichungstag der Anmeldung: 21.07.1993
(73) Patentinhaber: Grundig E.M.V. Elektro-Mechanische Versuchsanstalt Max Grundig GmbH & Co. KG, 90762 Fürth (DE)
(72) Erfinder: Wiekenberg, Günther, Dipl.-Ing. (FH), GRUNDIG EMV, Kurgartenstr. 37 W-8510 Fürth (DE); Mager, Gerhard, GRUNDIG E.M.V., Kurgartenstr. 37 W-8510 Fürth (DE)

(56) Entgegenhaltungen:
- DE-A- 3 630 209
- GB-A- 2 178 615
- US-A- 3 946 225

## Beschreibung

Die Erfindung betrifft einen drehbaren Codierer mit photoelektrischer Codierung. Verwendung finden derartige Codierer als Betriebsartenwählschalter, die neben der Wahl der Betriebsart noch die Funktionssteuerung der jeweils ausgewählten Betriebsart erlauben.

Für Geräte mit komplexen Bedienungsvorgängen ist es oftmals wünschenswert, den Bedienvorgang mit einem Bedienelement durchführen zu können, welches es zudem erlaubt, die Funktion der gewählten Betriebsart zu beeinflussen. Komplexe Bedienvorgänge lassen sich beispielsweise bei einem Videobandgerät finden, das eine Vielzahl von Bandbetriebsarten aufweist, wie z.B. Wiedergabe, Zurückspulen, schneller Vorlauf und Pause. Üblicherweise ist für jede der Betriebsarten ein Wählschalter vorgesehen. Wird ein bestimmter Wählschalter betätigt, so wird das entsprechende Steuersignal einem Motor zugeführt und das Band wird mit einer bestimmten Geschwindigkeit in eine bestimmte Richtung bewegt.

Besonders für Schneidezwecke ist es notwendig, bestimmte Bandstellen aufzufinden oder einen bestimmten Bereich eines mit einer Aufzeichnung versehenen Bandes bei einer gewünschten Bandgeschwindigkeit zu überprüfen. Die Auswahl der Betriebsarten mit den üblichen Wählschaltern ist dazu nicht ausreichend, da die nötige, sehr feine Steuerung des Bandes kaum möglich ist. Um diese Schwierigkeiten zu umgehen, muß ein zusätzlicher Steuergenerator vorgesehen werden, der die manuelle Einstellung der Funktion der ausgewählten Betriebsart erlaubt. Für die Einstellung der Bandbetriebsarten bedeutet dies, daß die Motorsteuersignale mittels des Steuergenerators veränderbar sein müssen.

Eine bekannte Realisierung eines Betriebsartenwählschalters mit Steuerimpulsgenerator zur Funktionssteuerung der jeweils ausgewählten Betriebsart zeigt die Offenlegungsschrift DE 36 25 599 A.

Bei dem bekannten Betriebsartenwählschalter mit Steuerimpulsgenerator werden zwei drehbare Codierer mit photoelektrischer Codierung verwendet. Die Codierer sind mittels einer inneren Achse sowie einer äußeren Achse, die koaxial zur inneren Achse verläuft, drehbar gelagert. Einer der Codierer dient als Betriebsartenwählschalter und der andere als Steuerimpulsgenerator, zur Steuerung der Funktion der jeweils ausgewählten Betriebsart.

Drehbare Codierer mit photoelektrischer Codierung enthalten eine drehbare Scheibe oder einen drehbaren Ring, die an ihrem Umfang eine Mehrzahl von Schlitzen tragen. Die Scheibe oder der Ring liegen innerhalb des Lichtweges einer Photodetektoreinrichtung. Die Photodetektoreinrichtung kann aus einer lichtaussendenden Diode und einem von dem ausgesendeten Licht gesteuerten Phototransistor gebildet werden. Die Drehung der Scheibe oder des Rings wird durch die Photodetektoreinrichtung aufgrund des Lichtdurchtritts durch die Schlitze ermittelt. Die Ausgangssignale der Photodetektoreinrichtung geben Auskunft über den Drehwinkel und die Drehgeschwindigkeit.

Neben der Verwendung einer Scheibe oder eines Rings ist es, z.B. aus der Patentschrift US 4,015,253, bekannt, eine lichtundurchlässige Trommel zu verwenden, mit einer Lichtquelle im Inneren der Trommel. Die Trommel weist lichtdurchlässige Stellen auf, die in mehreren konzentrischen Reihen entlang der Trommel angebracht sind und eine binäre Codierung ergeben, wenn jede Reihe an der Außenseite der Trommel von einem Photodetektor abgetastet wird. Durch mechanische Maßnahmen, z.B. eine Rastung, ist sichergestellt, daß nur eine schrittige Drehung der Trommel möglich ist. Damit wird erreicht, daß sich nach jeder beliebigen Drehung nur definierte Lagen ergeben, in denen der Lichtdurchtritt durch die lichtdurchlässigen Stellen der Trommel zu den Photodetektoren möglich ist.

Wird mindestens eine weitere Photodetektoreinrichtung verwendet, so läßt sich neben dem Drehwinkel und der Drehgeschwindigkeit zusätzlich die Drehrichtung bestimmen.

Eine andere Realisierungsform für den Codierer ergibt sich, wenn auf der Scheibe oder dem Ring reflektierende und nichtreflektierende Abschnitte im Wechsel aufgebracht werden. Das von der Diode ausgesendete Licht wird dann von den reflektierenden Abschnitten zurückgeworfen und steuert damit den Phototransistor an.

Als nachteilig anzusehen ist bei dem bekannten Aufbau des Betriebsartenwählschalters mit Steuerimpulsgenerator, daß wegen der Verwendung von zwei Codiereinrichtungen mindestens vier Photodetektoreinrichtungen benötigt werden.

Aufgabe der vorliegenden Erfindung ist es deshalb, einen Drehcodierer anzugeben, bei dem bei Verwendung von mehr als einer Codiereinrichtung eine Einsparung von Photodetektoreinrichtungen möglich ist.

Die Lösung der Aufgabe wird bei dem erfindungsgemäßen drehbaren Codierer dadurch erreicht, daß die drehbaren Codiereinrichtungen verkoppelt sind. Dadurch wird erreicht, daß nach einer beliebigen Drehung einer beliebigen Codiereinrichtung die Codiereinrichtung in eine Lage gebracht wird, in der sich immer die Lichtdurchlässe der Codiereinrichtungen gegenüberliegen. Es genügt deshalb, eine Photodetektoreinrichtung pro Codiereinrichtung vorzusehen und die zusätzlich nötige Drehrichtungsinformation für alle Codiereinrichtungen mittels einer gemeinsamen Photodetektoreinrichtung zu gewinnen. Die zusätzliche Photodetektoreinrichtung ist so angeordnet, daß ihr Lichtweg von allen Codiereinrichtungen unterbrochen werden kann.

Der Vorteil der vorliegenden Erfindung ist darin zu sehen, daß trotz der Einsparung von Photodetektoreinrichtungen bei drehbaren Codierern mit mehreren Codiereinrichtungen Informationen über Drehwinkel, Drehgeschwindigkeit und Drehrichtung abgeleitet werden können.

Im folgenden wird die Erfindung anhand zweier Figuren näher beschrieben. Dies geschieht anhand einer Ausführungsform des erfindungsgemäßen drehbaren Codierers, bei der Codierringe als drehbare Codiereinrichtungen verwendet werden. Die Erfindung wird dadurch aber nicht auf die Verwendung von Codierringen beschränkt, andere geeignete Codiereinrichtungen, wie z.B. Codierscheiben, sind möglich.

Es zeigen:
Figur 1 einen erfindungsgemäßen drehbaren Codierer mit zwei Codierringen, und
Figur 2 die Signale der Photodetektoreinrichtungen, wie sie durch abwechselndes Drehen der Codierringe nach Figur 2 erzeugt werden.

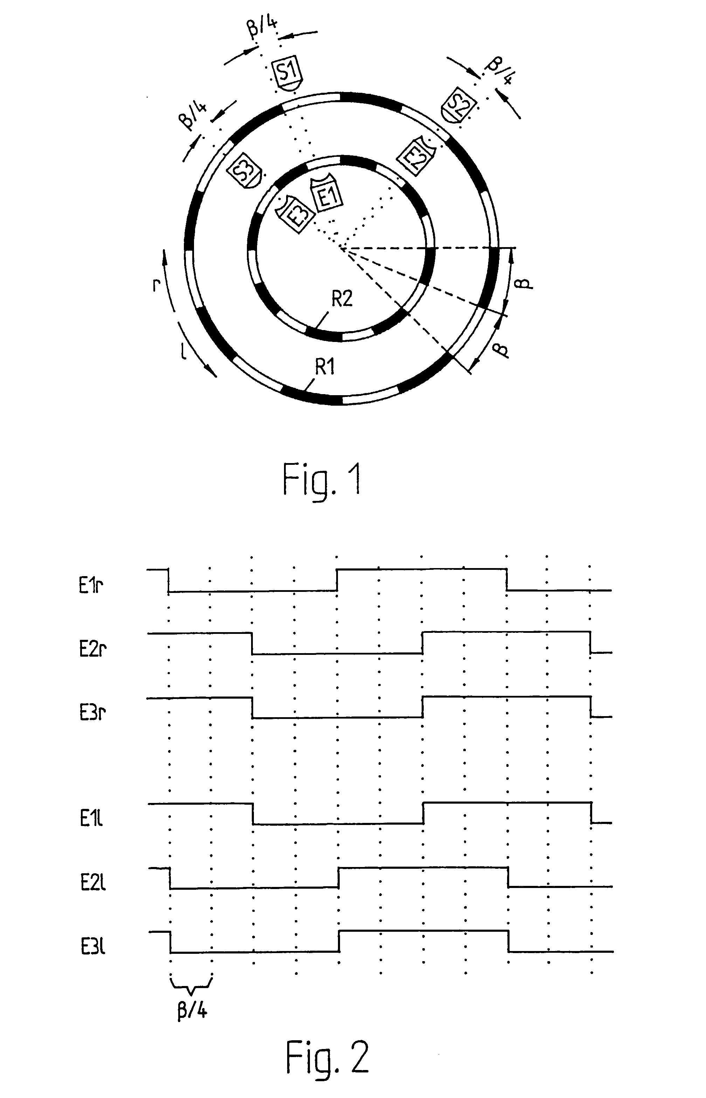

Die erfindungsgemäße Ausführungsform nach Figur 1 weist zwei Codierringe R1 und R2 auf, die bezüglich ihrer Drehachse koaxial zueinander angeordnet sind. Außerdem sind lichtaussendende Einrichtungen S1, S2 und S3 sowie lichtempfangende Einrichtungen E1, E2 und E3 vorhanden.

Die Einrichtungen S1 und E1 bilden eine Photodetektoreinrichtung, die von den Codierringen R1 und R2 beeinflußt werden kann. Die Einrichtungen S2 und E2 sind nur durch den Codierring R1 beeinflußbar, wohingegen der aus den Einrichtungen S3 und E3 gebildete Photodetektor nur von Codierring R2 beeinflußt werden kann.

Die Auflösung des Codierers, die mit den Codierringen erreicht werden kann, ist durch den Winkel β festgelegt, der die Größe der Lichtdurchlässe bzw. die lichtundurchlässigen Bereiche festlegt. Zur Steigerung der Auflösung des drehbaren Codierers ist es möglich, die Anzahl der Lichtdurchlässe zu erhöhen, d.h. der Winkel β muß verkleinert werden. Eine andere Möglichkeit besteht darin, eine feststehende Platte mit Lichtdurchlässen zu verwenden, die einen Abstand voneinander haben, der vom Abstand der Lichtdurchlässe der Codiereinrichtungen abweicht. Diese Verbesserung der Codiergenauigkeit wird in der Offenlegungsschrift DE 36 30 209 A näher beschrieben.

Die Codierringe R1 und R2 weisen Rastungen auf, die das Einrasten der Codierringe für Drehwinkel von zwei β bewirken. Dadurch ist sichergestellt, daß nach einer beliebigen Drehung der Codierringe R1 oder R2 die Codierringe R1 oder R2 eine Stellung einnehmen, in der sich die lichtdurchlässigen bzw. die lichtundurchlässigen Bereiche der Codierringe R1 und R2 gegenüberliegen. Durch diese Maßnahme ist sichergestellt, daß nach einer beliebigen Drehung eines der beiden Codierringe R1 oder R2 die Lichtausbreitung von der lichtaussendenden Einrichtung S1 zur lichtempfangenden Einrichtung E1 immer möglich ist. Unter dieser Voraussetzung kann die aus den Einrichtungen S1 und E1 gebildete Photodetektoreinrichtung sowohl für Codierring R1 als auch für Codierring R2 verwendet werden.

In Figur 2 ist für die Drehung des Codierrings R1 in Richtung r die Amplitude des von der lichtaussendenden Einrichtung S1 stammenden Lichtes am Ort der lichtempfangenden Einrichtung E1 als E1r dargestellt. An der Einrichtung E2 ergibt sich für die Lichtamplitude die Kurve E2r. Bei der Drehung von Codierring R2 in Richtung r ergeben sich am Ort der lichtempfangenden Einrichtung E1 die gleichen Amplitudenverhältnisse wie bei der Drehung des Codierrings R1. Kurve E3r zeigt die Verhältnisse an der lichtempfangenden Einrichtung E3.

Für die Drehung der Codierringe R1 oder R2 in Richtung 1 werden die Amplitudenverhältnisse durch die Kurven E1l, E21 und E31 beschrieben.

Durch die Auswertung der bei der Drehung der Codierscheiben R1 oder R2 entstandenen Impulse, d.h. der durch die Amplitudenwechsel an den lichtempfangenden Einrichtungen E1, E2 und E3 erzeugten Signale, können Drehwinkel, Drehgeschwindigkeit und Drehrichtung ermittelt werden. Um den Drehwinkel bestimmen zu können, muß die Anzahl der Amplitudenwechsel ermittelt und mit dem Winkel β multipliziert werden. Dies geschieht in vorteilhafter Weise mit den Signalen der lichtempfangenden Einrichtungen E2 oder E3, da damit gleichzeitig ermittelt werden kann, welcher der beiden Codierringe R1 oder R2 gedreht wird. Wird die Anzahl der Amplitudenwechsel innerhalb eines gewissen Zeitraums betrachtet, so erhält man Auskunft über die Drehgeschwindigkeit. Die Drehrichtung der Codierringe R1 und R2 läßt sich aus der unterschiedlichen Phasenlage der Signale der lichtempfangenden Einrichtungen E1, E2 und E3 ermitteln, die wegen des Versatzes der Photodetektoreinrichtungen um den Winkel β/4, wie in Figur 1 dargestellt, entsteht.

Die vorliegende Erfindung eignet sich auch für drehbare Codierer, die mehr als zwei Codiereinrichtungen aufweisen. Für alle weiteren Codiereinrichtungen kann die gemeinsame Photodetektoreinrichtung, wie bei dem drehbaren Codierer mit zwei Codiereinrichtungen, verwendet werden, falls die Codiereinrichtungen über die oben beschriebene Rastung verfügen. Auf diese Weise kann für jede weitere Codiereinrichtung eine Photodetektoreinrichtung eingespart werden.

Die Darstellung der Figur 1 gibt den prinzipiellen Aufbau des erfindungsgemäßen drehbaren Codierers wieder. Abweichungen von der dargestellten Anordnung der lichtsendenden und -empfangenden Einrichtungen sind möglich. Insbesondere sind auch andere Winkelverhältnisse als die angegebenen Winkel β bzw. β/4 möglich. Nicht dargestellt sind Einzelheiten der elektronischen Auswerteschaltungen sowie der mechanische Aufbau, da diese Einzelheiten für den Fachmann jederzeit aus dem vorbekannten Stand der Technik zu entnehmen sind.

## Patentansprüche

1. Drehbarer Codierer mit photoelektrischer Codierung, mit
- lichtemittierenden Einrichtungen (S1,S2,S3),
- lichtempfangenden Einrichtungen (E1,E2,E3), und
- drehbaren, koaxial gelagerten Codiereinrichtungen (R1,R2) mit einer Mehrzahl von in gleichem Abstand und in gleicher Größe angeordneten Lichtdurchlässen,
**dadurch gekennzeichnet**, daß
- eine lichtemittierende Einrichtung (S1) und eine lichtempfangende Einrichtung (E1) derart angeordnet sind, daß die Lichtausbreitung zwischen der lichtemittierenden Einrichtung (S1) und der lichtempfangenden Einrichtung (E1) von allen Codiereinrichtungen (R1;R2) unterbrochen werden kann,
- weitere lichtemittierende Einrichtungen (S2;S3) und weitere lichtempfangende Einrichtungen (E2;E3) jeweils nur von einer Codiereinrichtung (R1 oder R2) unterbrochen werden können, und
- die Codiereinrichtungen (R1;R2) nur schrittweise drehbar sind, wobei die Schrittweite dem Abstand zweier benachbarter Lichtdurchlässe entspricht, so daß sichergestellt ist, daß die Codiereinrichtungen (R1;R2) nach einer Drehung um jeden beliebigen Drehwinkel eine Endstellung einnehmen, in der die lichtdurchlässigen und lichtundurchlässigen Bereiche aller Codiereinrichtungen (R1;R2) einander gegenüberliegen.

2. Einrichtung nach Anspruch 1,
**dadurch gekennzeichnet**,
daß die Codiereinrichtungen (R1;R2) Scheiben sind, und daß die lichtemittierenden Einrichtungen (S1;S2;S3) und die lichtempfangenden Einrichtungen (E1;E2;E3) parallel zur Drehachse der Scheiben angeordnet sind.

3. Einrichtung nach Anspruch 1,
**dadurch gekennzeichnet**,
daß die Codiereinrichtungen (R1;R2) Ringe sind, und daß die lichtemittierenden Einrichtungen (S1;S2;S3) und die lichtempfangenden Einrichtungen (E1;E2;E3) senkrecht zur Drehachse der Scheiben angeordnet sind.

4. Einrichtung nach einem der Ansprüche 1 bis 3,
**dadurch gekennzeichnet**,
daß die Codiereinrichtungen (R1;R2) eine mechanische Rastung aufweisen, und daß die Rastabstände den Abständen der Lichtdurchlässe der Codiereinrichtungen (R1;R2) entsprechen.

## Claims

1. Rotating encoder with photoelectric coding, having
- light-emitting devices (S1, S2, S3),
- light-receiving devices (El, E2, E3), and
- rotating, coaxially-supported coding devices (Rl, R2) having a number of light-transparent regions of equal size arranged at equal distances,
**characterised in that**
- a light-emitting device (S1) and a light-receiving device (El) are arranged in such a way that the light propagation between the light-emitting device (S1) and the light-receiving device (El) can be interrupted by all coding devices (R1; R2),
- further light-emitting devices (S2; S3) and further light-receiving devices (E2; E3) can each be interrupted by only one coding device (R1 or R2), and
- the coding devices (R1; R2) can be rotated in steps only, the increment corresponding to the distance between two adjacent light-transparent regions, so as to ensure that after rotation through any arbitrary angle of rotation, the coding devices (R1; R2) assume an end position in which the light-transparent regions and non-light-transparent regions of all coding devices (R1; R2) lie opposite each other.

2. Device according to Claim 1, **characterised in that** the coding devices (R1; R2) are discs, and that the light-emitting devices (S1; S2; S3) and the light-receiving devices (El; E2; E3) are arranged parallel to the axis of rotation of the discs.

3. Device according to Claim 1, **characterised in that** the coding devices (R1; R2) are rings, and that the light-emitting devices (S1; S2; S3) and the light-receiving devices (E1; E2; E3) are arranged perpendicular to the axis of rotation of the discs.

4. Device according to one of Claims 1 to 3, **characterised in that** the coding devices (R1; R2) have a mechanical detent arrangement, and that the distances between the detents correspond to the light-transparent regions of the coding devices (R1; R2).

## Revendications

1. Codeur rotatif à codage photoélectrique comportant
- des dispositifs d'émission de lumière (S1,S2,S3),
- des dispositifs de réception de lumière (E1,E2,E3), et
- des dispositifs de codage rotatifs (R1,R2), montés coaxialement et comportant une multiplicité de passages pour la lumière, qui sont séparés par des distances identiques et ont les mêmes dimensions,
caractérisé en ce que
- un dispositif d'émission de lumière (S1) et un dispositif de réception de lumière (E1) sont disposés de telle sorte que la propagation de la lumière entre le dispositif d'émission de lumière (S1) et le dispositif de réception de lumière (E1) peut être interrompue par tous les dispositifs de codage (R1;R2),
- d'autres dispositifs d'émission de lumière (S2;S3) et d'autres dispositifs de réception de lumière (E2;E3) peuvent être interrompue respectivement uniquement par un dispositif de codage (R1 ou R2), et
- les dispositifs de codage (R1;R2) peuvent être entraînés en rotation seulement pas-à-pas, la largeur du pas correspondant à la distance entre deux passages voisins pour la lumière, ce qui garantit que les dispositifs de codage (R1;R2) occupent, après une rotation exécutée sur n'importe quel angle de rotation, une position d'extrémité, dans laquelle les zones, qui transmettent la lumière, et les zones, qui sont opaques à la lumière, de tous les dispositifs de codage (R1;R2) sont disposées en vis-à-vis.

2. Dispositif selon la revendication 1, caractérisé en ce que les dispositifs de codage (R1;R2) sont des disques, et que les dispositifs d'émission de lumière (S1;S2;53) et les dispositifs de réception de lumière (E1;E2;E3) sont disposés parallèlement à l'axe de rotation des disques.

3. Dispositif selon la revendication 1, caractérisé en ce que les dispositifs de codage (R1;R2) sont des anneaux et que les dispositifs d'émission de lumière (S1;S2;S3) et les dispositifs de réception de lumière (E1;E2;E3) sont disposés perpendiculairement à l'axe de rotation des disques.

4. Dispositif selon l'une des revendications 1 à 3, caractérisé en ce que les dispositifs de codage (R1;R2) possèdent des éléments d'encliquetage mécaniques et que les distances entre les éléments d'encliquetage correspondent aux distances entre les passages pour la lumière des dispositifs de codage (R1;R2).
